Europäisches Patentamt

European Patent Office

Office européen des brevets

(19)

(11) **EP 0 703 671 B1**

(12) **FASCICULE DE BREVET EUROPEEN**

(45) Date de publication et mention
de la délivrance du brevet:
**02.11.2000 Bulletin 2000/44**

(51) Int Cl.7: **H03K 19/0185**, H03K 19/00,
H03K 19/003

(21) Numéro de dépôt: **95402135.8**

(22) Date de dépôt: **22.09.1995**

(54) **Dispositif d'interfaçage de signaux logiques du niveau BTL au niveau TTL et CMOS**

Schnittstellenschaltung zwischen mit niedriger Versorgungsspannung betriebenem Logikschaltkreis
und TTL- bzw. CMOS-Schaltkreis

Interface circuit lying between a logic circuit having a low supply voltage and a TTL- or a CMOS-logic
circuit

(84) Etats contractants désignés:
**DE GB IT NL**

(30) Priorité: **26.09.1994 FR 9411436**

(43) Date de publication de la demande:
**27.03.1996 Bulletin 1996/13**

(73) Titulaire: **MHS**
**44087 Nantes Cédex 03 (FR)**

(72) Inventeurs:
• **Gerber, Rémi**
**F-44300 Nantes (FR)**
• **Silloray, Janick**
**F-44300 Nantes (FR)**

(74) Mandataire: **Fréchède, Michel et al**
**Cabinet Plasseraud**
**84, rue d'Amsterdam**
**F-75440 Paris Cédex 09 (FR)**

(56) Documents cités:
EP-A- 0 595 318   US-A- 5 115 434
US-A- 5 138 198

• **1992 SYMPOSIUM ON VLSI CIRCUITS, DIGEST
OF TECHNICAL PAPERS, JUNE 4-6, 1992,
SEATTLE pages 82 - 83 Y. NAKAGOME ET AL:
'Sub-1V Swing Bus Architecture for Future
Low-Power ULSIs'**

## Description

L'invention concerne un dispositif d'interfaçage de signaux logiques du niveau BTL au niveau TTL et CMOS.

Dans les circuits intégrés actuels, notamment les circuits logiques, il est primordial de permettre la commutation d'un niveau logique bas à un niveau logique haut, ou réciproquement, dans une plage d'amplitude de commutation réduite.

Pour cette raison, des circuits logiques à basse tension d'alimentation, circuits dits BTL, ont été développés, ces circuits permettant la commutation entre un niveau logique bas 1,1 volt et un niveau haut 1,9 volt. Ce type de circuits répond parfaitement aux critères de basse consommation d'énergie électrique, tant à l'état de veille qu'en commutation.

Toutefois, l'avènement de ce type de circuits pose le problème de leur incompatibilité avec les circuits logiques classiques tels que les circuits TTL (*Transistor Transistor Logic*) et CMOS pour lesquels les niveaux logiques bas et haut sont inférieur à 1,0 volt respectivement sensiblement égal à 5 volts. Le problème de compatibilité posé concerne non seulement les valeurs des tensions d'alimentation de ces circuits, lesquelles permettent d'engendrer les valeurs de tension correspondant au niveau logique haut, mais surtout la continuité de la transmission de l'information logique, en raison du risque d'ambiguïté entre le niveau logique haut du niveau BTL et le niveau logique bas du niveau TTL et CMOS.

Une solution au problème précité peut consister à engendrer une tension de seuil commune, intermédiaire entre le niveau logique haut BTL et le niveau logique bas TTL et CMOS, et à effectuer une discrimination de ces niveaux logiques par rapport à celle-ci.

Cette solution donne satisfaction, mais elle présente les inconvénients ci-après :

- présence d'une structure rapportée permettant d'engendrer la tension de seuil commune, et, le cas échéant, de discriminer les niveaux logiques précités ;
- consommation d'une surface importante dans le cas de l'intégration de cette structure rapportée sous forme d'un circuit intégré et consommation correspondante de silicium.

La demande de brevet européen EP-A-0 595 318 décrit un dispositif d'interfaçage dans lequel une valeur de tension commune intermédiaire à un niveau haut et un niveau bas est utilisée.

La présente invention a pour objet de remédier aux inconvénients précités par la mise en oeuvre d'un dispositif d'interfaçage des signaux logiques BTL au niveau TTL et CMOS dans lequel toute tension de seuil commune est supprimée.

Un autre objet de la présente invention est également la mise en oeuvre d'un dispositif d'interfaçage de signaux logiques BTL au niveau TTL et CMOS dans lequel la continuité de la transmission de l'information logique entre les deux types de circuit est assurée grâce à la mise en oeuvre de transitions entre valeurs de tension des niveaux logiques bas et haut d'amplitude progressives et compatibles.

Le dispositif d'interfaçage de signaux logiques du niveau BTL au niveau TTL et CMOS, objet de la présente invention, est remarquable en ce qu'il comprend, alimentés par une tension d'alimentation au niveau TTL par rapport à une tension de référence et connectés en cascade, un premier amplificateur-inverseur constitué par un amplificateur d'entrée à contre-réaction, présentant une auto-compensation assurant un gain constant en fréquence, ce premier amplificateur-inverseur recevant sur une entrée le signal logique au niveau BTL et délivrant un premier signal logique inversé, d'amplitude intermédiaire, un deuxième amplificateur-inverseur recevant le premier signal logique inversé d'amplitude intermédiaire et délivrant un deuxième signal logique d'amplitude intermédiaire amplifiée, un circuit de mise en forme recevant le deuxième signal logique d'amplitude intermédiaire amplifiée et délivrant un signal logique inversé au niveau TTL ; un circuit inverseur-amplificateur de puissance reçoit le signal logique inversé au niveau TTL et délivre un signal logique amplifié au niveau TTL.

Le dispositif d'interfaçage de signaux logiques du niveau BTL au niveau TTL et CMOS, objet de la présente invention, trouve application à l'industrie des circuits intégrés.

Il sera mieux compris à la lecture de la description et à l'observation des dessins ci-après, dans lesquels :

- la figure 1 représente un schéma fonctionnel et d'implantation du dispositif d'interfaçage de signaux logiques, objet de la présente invention ;
- la figure 2 représente un chronogramme de signaux relevés en des points de test remarquables du dispositif représenté en figure 1.

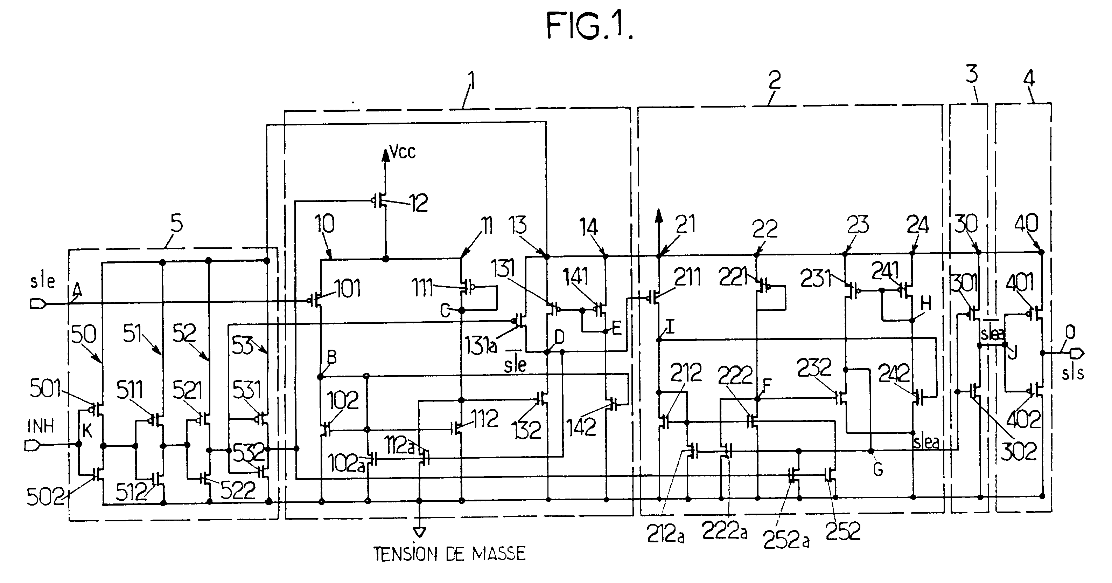

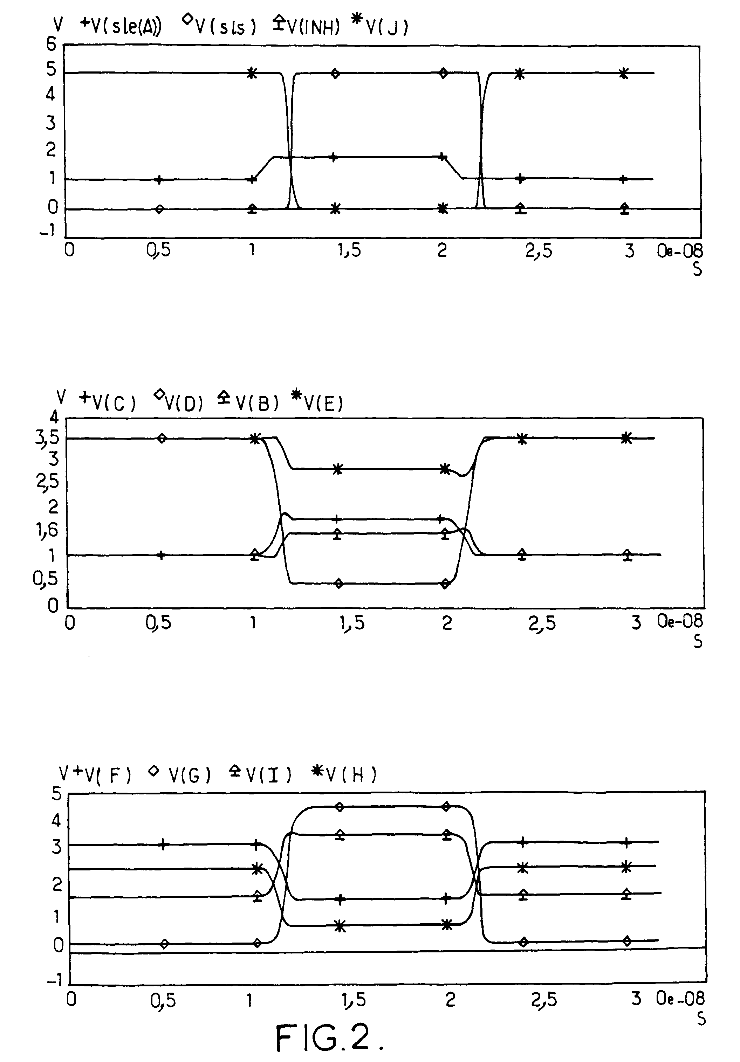

Une description plus détaillée du dispositif d'interfaçage de signaux logiques, objet de la présente invention, sera maintenant donnée en liaison avec la figure 1 puis la figure 2.

Ainsi qu'on l'a représenté sur la figure 1, le dispositif d'interfaçage de signaux logiques du niveau BTL au niveau TTL et CMOS, objet de la présente invention, comprend, alimentés par une tension d'alimentation VCC au niveau TTL par rapport à une tension de référence ou tension de masse, et connectés en cascade, un premier amplificateur-inverseur 1, lequel reçoit sur une entrée correspondant à un point de test A un signal logique d'entrée, noté sle, au niveau BTL et délivrant un premier signal logique inversé d'amplitude intermédiaire, noté $\overline{sle}$. Le premier signal logique inversé $\overline{sle}$ d'am-

plitude intermédiaire est délivré au point de test D de la figure 1.

En outre, le dispositif d'interfaçage selon l'invention comprend un deuxième amplificateur-inverseur 2, lequel reçoit le premier signal logique inversé $\overline{sle}$ d'amplitude intermédiaire, et délivre un deuxième signal logique d'amplitude intermédiaire amplifiée, noté slea. Le deuxième signal logique d'amplitude intermédiaire amplifiée, noté slea, est plus particulièrement délivré au point de test G de la figure 1.

Le dispositif d'interfaçage, objet de la présente invention, comporte également, connecté en cascade avec le deuxième amplificateur-inverseur 2, un circuit 3 de mise en forme recevant le deuxième signal logique d'amplitude intermédiaire amplifiée slea et délivrant un signal logique inversé au niveau TTL, noté $\overline{slea}$ sur la figure 1 précitée. Ce signal est plus particulièrement délivré au point de test J de la figure 1.

Un circuit 4 inverseur-amplificateur de puissance est enfin prévu, connecti en cascade au circuit 3 de mise en forme et recevant le signal logique inversé au niveau TTL $\overline{slea}$, et délivrant un signal logique amplifié au niveau TTL, le signal sls de sortie du dispositif d'interfaçage, objet de la présente invention. Le signal logique amplifié au niveau TTL, sls, est plus particulièrement délivré au point de test O sur la figure 1.

En outre, de manière non-limitative, le dispositif d'interfaçage de signaux logiques du niveau BTL au niveau TTL et CMOS, objet de la présente invention, peut comprendre un circuit 5 de commande recevant un signal de commande permettant de réduire le consommation statique d'énergie électrique en mode veille, ce signal de commande étant noté INH et étant introduit au point de test K de la figure 1 précitée.

Une description plus détaillée de l'ensemble des différents modules constitutifs du dispositif d'interfaçage de signaux logiques, objet de la présente invention, sera maintenant donnée également en liaison avec la figure 1.

Ainsi que représenté sur la figure précitée, le premier amplificateur-inverseur 1 comprend, par exemple, un premier étage inverseur, noté 10, formé par deux transistors MOS, P,N, portant les références 101 et 102 et connectés en cascade. La grille du transistor MOS P 101 forme le port d'entrée du dispositif d'interfaçage et reçoit le signal logique au niveau BTL, c'est-à-dire le signal logique d'entrée sle au point de test A de la figure 1. Un deuxième étage inverseur 11 est prévu, lequel est formé par deux transistors MOS P,N, notés 111,112, ces transistors 111,112 étant connectés en cascade. Le premier 10 et le deuxième 11 étage inverseur sont connectés en parallèle entre la tension de référence, tension de masse, et un point commun auquel est connectée l'électrode de source des transistors MOS 101 et 111. En outre, un transistor MOS P de puissance, noté 12, est interconnecté entre la tension d'alimentation VCC et le point commun entre le premier 10 et le deuxième inverseur 11 précédemment mentionnés.

En outre, un troisième étage inverseur 13 est prévu, lequel est formé par deux transistors MOS P,N référencés 131,132 et connectés en cascade entre la tension d'alimentation VCC et la tension de référence ou tension de masse. Le point commun entre les transistors MOS P,N 131 et 132 du troisième étage inverseur 13 forme la borne de sortie du premier amplificateur-inverseur 1 au point de test D de la figure 1. Cette borne de sortie délivre le premier signal logique inversé d'amplitude intermédiaire, noté $\overline{sle}$.

Enfin, un quatrième étage inverseur 14 est prévu, cet étage inverseur étant formé par deux transistors MOS P,N portant les références 141, 142, ces transistors étant connectés en cascade. La grille du transistor MOS P 141 du quatrième étage inverseur 14 est connectée au point commun des transistors MOS P et N 141, 142 du quatrième étage inverseur 14 et la grille du transistor MOS N 142 de ce même quatrième étage inverseur est connectée au point commun du premier étage inverseur 10 du premier amplificateur-inverseur 1, c'est-à-dire au point de test B de la figure 1.

Ainsi qu'il apparaît en outre sur la figure 1 relativement au premier amplificateur-inverseur 1, un circuit de contre-réaction est formé par un premier, 102a, et un deuxième, 112a, transistor MOS N de contre-réaction, lesquels sont connectés chacun en parallèle sur le transistor MOS N 102,112 du premier respectivement du deuxième étage inverseur 10,11. La grille des transistors de contre-réaction 102a, 112a est connectée en sortie du premier amplificateur-inverseur, c'est-à-dire au point de test D de la figure 1.

En ce qui concerne le deuxième amplificateur-inverseur 2, ainsi que représenté en figure 1, celui-ci comprend un premier 21, un deuxième 22, un troisième 23 et un quatrième 24 étage inverseur, chacun formé par deux transistors MOS P,N portant les références 211,212 ; 221,222 ; 231,232 ; 241,242, les couples de transistors MOS précités étant connectés en cascade. Ces étages inverseurs sont connectés en parallèle entre la tension d'alimentation VCC et la tension de référence, tension de masse. La sortie du premier amplificateur-inverseur 1, c'est-à-dire le point de test D de la figure 1, est connectée à la grille du transistor MOS P 211 du premier étage inverseur 21 pour assurer l'interconnexion entre la sortie du premier amplificateur-inverseur 1 et l'entrée du deuxième amplificateur-inverseur 2. Le point commun entre le transistor MOS P 211 et le transistor MOS N 212 du premier étage inverseur 21 est connecté à la grille du transistor MOS N 242 du quatrième étage inverseur 24. La grille des transistors MOS P 221 ; 231 ; 241 du deuxième 22, respectivement troisième 23 et quatrième 24 étages inverseurs est interconnectée au point commun du deuxième 22, respectivement du quatrième étage inverseur 24. Le point commun des transistors MOS P, N 231,232 du troisième étage inverseur 23 forme la sortie du deuxième étage amplificateur inverseur 2 et délivre le deuxième signal logique d'amplitude intermédiaire amplifiée slea au point de test G de la figure 1.

En outre, un circuit de contre-réaction est prévu, lequel est formé par un premier 212a et un deuxième 222a transistor MOS N de contre-réaction, lesquels sont connectés chacun en parallèle sur le transistor MOS N 212,222 du premier 21 respectivement deuxième 22 étage inverseur. La grille des transistors de contre-réaction 212a, 222a est connectée en sortie du deuxième amplificateur-inverseur 2.

En ce qui concerne le circuit de mise en forme 3, ainsi qu'il apparaît sur la figure 1, celui-ci comprend un étage inverseur 30 formé par deux transistors MOS P, N 301,302 connectés en cascade. Les grilles des transistors MOS P, N sont reliées en parallèle en sortie du deuxième amplificateur-inverseur 2, en particulier au point de test G de la figure 1, et forment ainsi une borne d'entrée pour le circuit de mise en forme 3 précité. Le point commun des transistors MOS P, N 301,302 forme une borne de sortie du circuit de mise en forme 3 et délivre le signal logique inversé au niveau TTL, le signal $\overline{slea}$ au circuit 4 inverseur-multiplicateur de puissance.

Enfin, en ce qui concerne le circuit inverseur-amplificateur de puissance 4, celui-ci comprend un étage inverseur formé par deux transistors MOS P, N, notés 401,402, connectés en cascade. La grille des transistors MOS P, N forme borne d'entrée du circuit inverseur-amplificateur de puissance 4, ces grilles étant connectées en parallèle en sortie du circuit de mise en forme 3 au point de test J de la figure 1. Le point commun des deux transistors MOS P, N 401,402 forme une borne de sortie du circuit inverseur-amplificateur et délivre le signal logique amplifié au niveau TTL, sls formant le signal logique de sortie pour le dispositif d'interfaçage de signaux logiques du niveau BTL au niveau TTL et CMOS, objet de l'invention.

Dans un mode de réalisation avantageux, on indique que le dispositif d'interfaçage de signaux logiques du niveau BTL au niveau TTL et CMOS, selon l'invention, peut comprendre le circuit de commande 5 permettant de réduire la consommation statique de l'énergie électrique en mode veille, ce circuit pouvant comprendre par exemple, ainsi que représenté en figure 1, un premier 50, un deuxième 51, un troisième 52 et un quatrième 53 étage inverseur, formés chacun par deux transistors MOS P, N 501,502 ; 511,512 ; 521,522 ; 531,532 montés en cascade, ces étages inverseurs étant connectés en parallèle entre la tension d'alimentation et la tension de référence ou tension de masse. Le point commun des transistors MOS P, N est connecté aux grilles des transistors MOS P, N de l'étage inverseur suivant, le point commun des transistors MOS P, N 531,532 du quatrième et dernier étage inverseur 53 forme une borne de sortie du circuit de commande 5, cette borne de sortie étant connectée, d'une part, à la grille du transistor MOS P de puissance 12 du premier amplificateur-inverseur 1 et, d'autre part, à la grille d'un premier 252 et d'un deuxième 252a transistor MOS N inhibiteur. Le premier 252 et le deuxième 252a transistor MOS N sont connectés en parallèle entre grille et tension de référence, tension de masse, des transistors de contre-réaction 212a du deuxième amplificateur-inverseur 2, respectivement entre grille et tension de référence des transistors MOS 212, 222 du premier 21 et du deuxième 22 étage inverseur du deuxième amplificateur-inverseur 2.

Le fonctionnement du dispositif d'interfaçage de signaux logiques du niveau BTL au niveau TTL et CMOS, objet de la présente invention, sera maintenant décrit en liaison avec les figures 1 et 2.

Le premier amplificateur-inverseur 1 est un amplificateur d'entrée à contre-réaction, cet amplificateur étant composé d'un système présentant un gain et une structure imposant une auto-compensation afin d'assurer la stabilité du système. La contre-réaction est assurée par l'intermédiaire des transistors de contre-réaction 102a, 112a précédemment cités. Ce mode opératoire permet d'obtenir un gain global plus faible mais constant en fréquence et peu sensible aux variations de la température, de la tension d'alimentation VCC ainsi que du processus de fabrication.

A titre d'exemple non-limitatif, le point de test A étant fixé au départ, c'est-à-dire à la valeur du niveau logique bas BTL, soit 1,1 volt, lors d'une transition, c'est-à-dire d'un passage au niveau logique haut à la valeur 1,9 volt, cette transition provoque l'abaissement de la tension au point de test B et, du fait du couplage du premier 10 et du deuxième étage inverseur, la tension au point de test C augmente. La tension au point de test B diminuant, la tension au point de test E s'élève au contraire, alors que la tension au point de test D diminue très rapidement en raison de l'impédance ramenée entre le point de test D et la tension d'alimentation VCC, cette impédance augmentant fortement en raison du fait que le point de test E vient en fait réduire la tension grille-source du transistor 131 pour la rapprocher de la tension de seuil de ce dernier. La tension au point de test D diminuant fortement, la tension au point de test B s'élève au contraire, et la tension au point de test C continue à s'élever. La tension aux points de test B et C augmentant, la tension au point de test E diminue légèrement et la tension au point de test D continue à diminuer fortement, cette diminution de tension au point de test D étant toutefois limitée par l'abaissement de la tension du point de test E en raison de la diminution de l'impédance ramenée entre le point de test D et la tension d'alimentation VCC.

On comprend bien sûr qu'en ce qui concerne une transition opposée du signal logique BTL d'entrée sle, un abaissement de la tension au point de test A, c'est-à-dire une transition de la valeur du niveau logique haut 1,9 volt à la valeur de tension du niveau logique bas 1,1 volt, les tensions aux points de test précédemment cités évoluent en sens contraire.

Alors que la tension de transition de tension du niveau logique haut au niveau logique bas ou réciproquement du niveau logique bas au niveau logique haut du signal logique d'entrée BTL évolue entre les valeurs 1,9 volt et 1,1 volt ou réciproquement, on comprend que le premier signal logique inversé $\overline{sle}$ délivré par le premier amplificateur-inverseur 1 évolue de manière inverse entre deux valeurs de tension dites intermédiaires qui sont inférieure à la valeur de tension du niveau logique haut, respectivement supérieure à la valeur de tension du niveau logique bas du niveau TTL. Typiquement, ces valeurs peuvent être 3,5 volts et 0,5 volt.

Le deuxième amplificateur-inverseur 2 est un amplificateur intermédiaire du même type que celui précédemment décrit relativement au premier amplificateur intermédiaire 1, mais il présente toutefois un point d'équilibre différent, ce point d'équilibre étant compris entre les valeurs de tension précédemment mentionnées.

Le point de test A étant par exemple fixé au départ, c'est-à-dire à la valeur du niveau logique bas BTL 1,1 volt, lors d'une transition vers le niveau logique haut à la valeur 1,9 volt, la tension au point de test D diminue rapidement de la valeur du niveau logique haut 3,5 volts à la valeur du niveau logique bas 0,5 volt, ces valeurs constituant les niveaux logiques intermédiaires pour le deuxième amplificateur-inverseur 2. En raison de la chute rapide de la tension au point de test D, la tension au point de test I, point commun du premier étage inverseur 21, s'élève au contraire, et la tension au point de test F s'abaisse en conséquence. La tension au point de test I s'élevant, la tension au point de test H s'abaisse en conséquence également et la tension grille-source entre le point de test H pour les transistors MOS de type P 231 et 241 s'élève et l'impédance vue entre le point de test G et la tension d'alimentation VCC diminue fortement. La tension au point de test G s'élève alors d'autant plus que la tension au point de test F s'abaisse. Cette dernière tension au point de test F s'abaissant, l'impédance vue entre le point de test G et la tension de référence ou masse augmente fortement et confirme encore la montée de la tension au point de test G.

Pour ce qui concerne au contraire la transition inverse de montée en tension au point de test D de 0,5 volt à 3,5 volts, il suffit de reprendre le descriptif précédent en considérant que l'ensemble des tensions aux points de test évoluent dans le sens contraire de celui décrit précédemment. En conséquence, le signal logique d'entrée amplifié slea délivré en sortie du deuxième amplificateur-inverseur 2 varie dans le même sens que le signal logique d'entrée mais avec un niveau d'amplitude de transition supérieur, ainsi que représenté sur la figure 2, entre des valeurs comprises entre 0,5 volt pour le niveau logique bas et 4,5 volts pour le niveau logique haut.

En ce qui concerne le module de mise en forme 3, celui-ci a pour objet de transformer les variations de tension du point de test G, c'est-à-dire le signal logique d'entrée amplifié slea précédemment décrit tel que délivré par le deuxième amplificateur-inverseur 2, en des variations de tension au niveau CMOS. Le circuit de mise en forme 3 est donc constitué par l'inverseur CMOS 30 dont le point de commutation a été choisi sensiblement au milieu de l'excursion de la tension au point de test G, c'est-à-dire à la valeur de 2,5 volts environ.

Enfin, en ce qui concerne le circuit 4 inverseur-amplificateur de puissance, celui-ci est constitué par un inverseur de type CMOS permettant d'augmenter le courant en sortie lors de la commutation. Il permet donc d'effectuer une commutation rapide avec des temps de montée et de descente relativement courts. Il reçoit bien entendu le signal constitué par les transitions entre les niveaux logiques de type CMOS, 5 volts pour le niveau logique haut, 0 volt pour le niveau logique bas, délivrées au point de test J par le circuit 3 de mise en forme, ainsi que représenté en figure 2.

Le circuit 5 de commande permettant de réduire la consommation statique d'énergie électrique en mode de veille reçoit un signal de commande, noté INH, permettant non seulement de couper la consommation statique du premier et du deuxième étage amplificateur 1,2 et donc d'arrêter leur fonctionnement, mais aussi d'engendrer un niveau CMOS en sortie afin d'inhiber la consommation statique de toute cellule connectée en aval du circuit 4 inverseur amplificateur de puissance, constituant en fait étage de sortie du dispositif d'interfaçage de signaux logiques du niveau BTL au niveau TTL et CMOS, objet de la présente invention. Le transistor 131a coupe l'alimentation VCC grâce aux transistors 211, 102a et 112a. Ainsi, lorsque le signal d'inhibition INH est au niveau logique bas, 0 volt, le dispositif d'interfaçage objet de la présente invention, fonctionne normalement, ainsi que décrit précédemment en liaison avec les figures 1 et 2. Au contraire, lorsque ce même signal INH est au niveau logique haut, c'est-à-dire à la valeur de la tension d'alimentation VCC, le premier et le deuxième amplificateur-inverseur 1,2 sont bloqués et ne consomment aucune énergie électrique en statique. En outre, le point de test O de la sortie, qui normalement délivre le signal de sortie sls, est à la tension de référence, tension de masse.

Bien entendu, le dispositif d'interfaçage de signaux logiques du niveau BTL au niveau TTL et CMOS, objet de la présente invention, est, de préférence, utilisé sous forme de circuits intégrés en technologie CMOS.

Dans ces conditions, le premier circuit amplificateur-inverseur 1, le deuxième amplificateur-inverseur 2, le circuit 3 de mise en forme et le circuit 4 inverseur-amplificateur sont très peu sensibles à des variations minimes de la largeur de canal des transistors N mis en oeuvre, ce qui permet d'envisager tous types d'applications notamment dans les conditions les plus rudes. En effet, dans un tel cas, il est nécessaire de positionner des vignettes au niveau des becs d'oiseaux engendrés au niveau des grilles de polysilicium passant de l'oxyde épais à l'oxyde mince des transistors N afin d'éviter le contournement par l'extérieur du transistor N du courant drain-source. Une telle mesure peut être évitée en raison du fait que le dispositif d'interfaçage, objet de la présente invention, est en fait équipé du premier et du deuxième amplificateurs-inverseurs 1,2 montés en cascade avec contre-réaction, l'ensemble du dispositif restant de ce fait parfaitement fonctionnel.

En outre, le dispositif d'interfaçage objet de l'invention, garde toutefois les mêmes propriétés électriques de temps de propagation et de temps de montée et de descente.

On a ainsi décrit un dispositif d'interfaçage de signaux logiques du niveau BTL au niveau TTL et CMOS permettant d'effectuer l'interfaçage entre deux types de circuits logiques présentant des niveaux logiques différents, l'un, BTL, l'autre, CMOS.

Cette mise en oeuvre est particulièrement avantageuse dans la mesure où elle permet la commutation entre ces deux types de circuits logiques dans les extrêmes de variations de tension, de température et de procédé de fabrication sans toutefois nécessiter l'introduction d'une tension de seuil commune. En outre, le dispositif d'interfaçage selon l'invention présente une structure simple d'implantation et d'utilisation très aisées.

## Revendications

1. Dispositif d'interfaçage de signaux logiques du niveau BTL au niveau TTL et CMOS, caractérisé en ce qu'il comprend, alimentés par une tension d'alimentation au niveau TTL par rapport à une tension de référence, et connectés en cascade :

   - un premier amplificateur-inverseur (1), constitué par un amplificateur d'entrée à contre-réaction, présentant une auto-compensation assurant un gain constant en fréquence, ce premier amplificateur inverseur recevant sur une entrée ledit signal logique au niveau BTL et délivrant un premier signal logique inversé, d'amplitude intermédiaire,
   - un deuxième amplificateur-inverseur (2), recevant ledit premier signal logique inversé d'amplitude intermédiaire et délivrant un deuxième signal logique d'amplitude intermédiaire amplifiée,
   - un circuit (3) de mise en forme, recevant ledit deuxième signal logique d'amplitude intermédiaire amplifiée et délivrant un signal logique inversé au niveau TTL,
   - un circuit (4) inverseur-amplificateur de puissance recevant ledit signal logique inversé au niveau TTL et délivrant un signal logique amplifié au niveau TTL.

2. Dispositif selon la revendication 1, caractérisé en ce que lesdits premier et deuxième amplificateurs-inverseurs comportent un circuit (5) de commande recevant un signal de commande permettant de réduire la consommation statique d'énergie électrique en mode veille.

3. Dispositif selon la revendication 1 ou 2, caractérisé en ce que ledit premier amplificateur-inverseur (1) comprend :

   - un premier (10) étage inverseur formé par deux transistors MOS P, N (101,102) connectés en cascade, la grille du transistor MOS P (101) formant entrée du dispositif d'interfaçage et recevant ledit signal logique au niveau BTL,
   - un deuxième (11) étage inverseur formé par deux transistors MOS P, N (111,112) connectés en cascade, le premier et le deuxième étage inverseur étant connectés en parallèle entre la tension de référence et un point commun,
   - un transistor MOS P de puissance (12) interconnecté entre la tension d'alimentation et le point commun,
   - un troisième (13) étage inverseur formé par deux transistors MOS P, N (131,132) connectés en cascade, entre la tension d'alimentation et la tension de référence, le point commun entre transistors MOS P, N du troisième étage inverseur formant borne de sortie dudit premier amplificateur-inverseur et délivrant ledit premier signal logique inversé d'amplitude intermédiaire,
   - un quatrième (14) étage inverseur, la grille du transistor MOS P (141) du quatrième étage inverseur (14) étant connectée au point commun des transistors MOS P et N (141, 142) dudit quatrième étage inverseur et la grille du transistor MOS N (142) du quatrième étage inverseur (14) étant connectée au point commun du premier étage inverseur (10) du premier amplificateur-inverseur (1),
   - un circuit de contre-réaction formé par un premier (102a) et un deuxième (112a) transistor MOS N de contre-réaction connectés chacun en parallèle sur le transistor MOS N (102,112) du premier respectivement deuxième étage inverseur, la grille desdits transistors de contre-réaction étant connectée en sortie dudit premier amplificateur-inverseur.

4. Dispositif selon l'une des revendications 1 à 3, caractérisé en ce que ledit deuxième amplificateur-inverseur (2) comprend :

   - un premier, un deuxième, un troisième et un quatrième étage inverseur (21, 22, 23, 24), chacun formé par deux transistors MOS P, N (211,212 ; 221,222 ; 231,232 ; 241,242) connectés en cascade, lesdits étages inverseurs étant connectés en parallèle entre la tension d'alimentation et la tension de référence, la sortie du premier amplificateur-inverseur (1) étant connectée à la grille du transistor MOS P (211) dudit premier étage inverseur (21), pour assurer l'interconnexion entre la sortie du premier amplificateur-inverseur (1) et l'entrée du deuxième amplificateur-inverseur (2), le point commun entre le transistor MOS P (211) et le transistor N (212) dudit premier étage inverseur (21) étant connecté à la grille du transistor MOS N (232) dudit troisième étage inverseur (23), et la grille des transistors MOS P (221 ; 231, 241) desdits deuxième, troisième et quatrième étages inverseurs (22 ; 23, 24) étant interconnectée au point commun du deuxième étage inverseur (22) respectivement du quatrième étage inverseur (24), le point commun des transistors MOS P, N (231, 232) du troisième étage inverseur (23) formant la sortie dudit deuxième amplificateur inverseur (2) délivrant ledit deuxième signal logique d'amplitude intermédiaire amplifiée,

- un circuit de contre-réaction formé par un premier (212a) et un deuxième (222a) transistor MOS N de contre-réaction connectés chacun en parallèle sur le transistor MOS N (212, 222) du premier (21) respectivement deuxième (22) étage inverseur, la grille desdits transistors de contre-réaction (212a, 222a) étant connectée en sortie dudit deuxième amplificateur-inverseur (2).

5. Dispositif selon l'une des revendications 1 à 4, caractérisé en ce que ledit circuit de mise en forme (3) comprend un étage inverseur (30) formé par deux transistors MOS P, N (301, 302) connectés en cascade, les grilles desdits transistors MOS P, N formant entrée dudit circuit de mise en forme étant connectées en sortie dudit deuxième amplificateur inverseur (2) et le point commun desdits transistors MOS P, N formant sortie dudit circuit de mise en forme (3) délivrant ledit deuxième signal logique inversé au niveau TTL.

6. Dispositif selon l'une des revendications 1 à 5, caractérisé en ce que ledit circuit inverseur-amplificateur de puissance (4) comprend un étage inverseur formé par deux transistors MOS P, N (401, 402) connectés en cascade, la grille desdits transistors MOS P, N formant entrée dudit circuit inverseur-amplificateur de puissance étant connectée en sortie dudit circuit de mise en forme (3) et le point commun des deux transistors MOS P, N (401, 402) formant sortie dudit circuit inverseur-amplificateur délivrant ledit signal logique amplifié au niveau TTL.

7. Dispositif selon l'une des revendications 2 à 6, caractérisé en ce que le circuit de commande (5) permettant de réduire la consommation statique d'énergie électrique en mode veille comprend : un premier (50), deuxième (51), troisième (52) et quatrième (53) étage inverseur formés chacun par deux transistors MOS P, N (501,502 ; 511,512 ; 521,522 ; 531,532) en cascade, ces étages inverseurs étant connectés en parallèle entre la tension d'alimentation et la tension de référence, le point commun desdits transistors MOS P, N étant connecté aux grilles des transistors MOS P, N de l'étage inverseur suivant, le point commun des transistors MOS P, N (531,532) du quatrième étage inverseur formant sortie du circuit de commande (5) étant connecté, d'une part, à la grille dudit transistor MOS P de puissance (12) dudit premier amplificateur-inverseur (1), et, d'autre part, à la grille d'un premier (252) et d'un deuxième (252a) transistor MOS N inhibiteur connecté en parallèle entre grille et tension de référence desdits transistors de contre-réaction (212a) du deuxième amplificateur-inverseur, respectivement entre grille et tension de référence des transistors MOS N (212, 222) du deuxième (21) et du troisième (22) étage inverseur du deuxième amplificateur-inverseur (2).

## Patentansprüche

1. Schnittstellenschaltung für Lokigsignale zwischen mit niedriger Versorgungsspannung auf TTL- bzw. CMOS-Pegel,

 **dadurch gekennzeichnet, daß** sie folgende Elemente aufweist, die mit einer TTL-Versorgungsspannung gegenüber einer Referenzspannung gespeist werden und kaskadengeschaltet sind:

- einen ersten invertierenden Verstärker (1), bestehend aus einem Rückkopplungs-Eingangsverstärker, der eine Selbstkompensation aufweist, die einen konstanten Verstärkungsfaktor über die Frequenz gewährleistet, wobei dieser erste invertierende Verstärker an einem Eingang das genannte Lokigsignal mit niedrigem Spannungspegel empfängt und ein erstes invertiertes Lokigsignal mit mittlerer Amplitude abgibt,
- einen zweiten invertierenden Verstärker (2), der dieses erste invertierte Logiksignal mit mittlerer Amplitude empfängt und ein zweites logisches Signal mit verstärkter mittlerer Amplitude abgibt,
- eine Signalformerschaltung (3), die dieses zweite logische Signal mit verstärkter mittlerer Amplitude empfängt und ein invertiertes Logiksignal auf TTL-Pegel abgibt,
- einen invertierenden Leistungsverstärker (4), der dieses invertierte Logiksignal auf TTL-Pegel empfängt und ein verstärktes Logiksignal auf TTL-Pegel abgibt.

2. Schnittstellenschaltung nach Anspruch 1, **dadurch gekennzeichnet, daß** diese beiden invertierenden Verstärker eine Steuerschaltung (5) aufweisen, die ein Steuersignal empfängt, das es ermöglicht, den statischen Stromverbrauch im Standby-Modus zu reduzieren.

3. Schnittstellenschaltung nach Anspruch 1 oder 2, **dadurch gekennzeichnet, daß** dieser erste invertierende Verstärker (1) aufweist:

   - eine erste Inverterstufe (10), die aus zwei in Kaskade geschalteten P-, NMOS-Transistoren (101, 102) besteht, wobei das Gate des PMOS-Transistors (101) den Eingang der Schnittstellenschaltung bildet und das genannte Logiksignal mit niedriger Spannung empfängt,
   - eine zweite Inverterstufe (11), die aus zwei in Kaskade geschalteten P-, NMOS-Transistoren (111, 112) besteht, wobei die erste und die zweite Inverterstufe zwischen der Referenzspannung und einem gemeinsamen Pol parallel geschaltet sind,
   - einen PMOS-Leistungstransistor (12), der zwischen der Versorgungsspannung und dem gemeinsamen Pol zwischengeschaltet ist,
   - eine dritte Inverterstufe (13), die aus zwei in Kaskade geschalteten P-, NMOS-Transistoren (131, 132) zwischen der Versorgungsspannung und der Referenzspannung besteht, wobei der gemeinsame Pol zwischen den P-, N-Transistoren der dritten Inverterstufe den Ausgangsanschluß des genannten ersten invertierenden Verstärkers bildet und das genannte erste invertierte Logiksignal mit mittlerer Amplitude abgibt,
   - eine vierte Inverterstufe (14), wobei das Gate des PMOS-Transistors (141) der vierten Inverterstufe (14) mit dem gemeinsamen Pol der P-, NMOS-Transistoren (141, 142) dieser vierten Inverterstufe verbunden ist und das Gate des NMOS-Transistors (142) der vierten Inverterstufe (14) mit dem gemeinsamen Pol der ersten Inverterstufe (10) des ersten Invertierender Verstärkers (1) verbunden ist,
   - eine Rückkopplungs-Schaltung, bestehend aus einem ersten und einem zweiten Rückkopplungs-NMOS-Transistor (102a, 112a), die jeweils parallel mit dem NMOS-Transistor (102, 112) der ersten bzw. zweiten Inverterstufe verbunden sind, wobei das Gate dieser Rückkopplungs- Transistoren am Ausgang dieses ersten invertierenden Verstärkers angeschlossen ist.

4. Schnittstellenschaltung nach einem der Ansprüche 1 bis 3, **dadurch gekennzeichnet, daß** der genannte zweite invertierende Verstärker (2) aufweist:

   - eine erste, eine zweite, eine dritte und eine vierte Inverterstufe (21, 22, 23, 24), die jeweils aus zwei in Kaskade geschalteten P-, NMOS-Transistoren (211, 212; 221, 222; 231, 232; 241, 242) bestehen, wobei diese Inverterstufen parallel zwischen der Versorgungsspannung und der Referenzspannung geschaltet sind, wobei der Ausgang des ersten invertierenden Verstärkers (1) mit dem Gate des PMOS-Transistors (211) der genannten ersten Inverterstufe (21) verbunden ist, um die Verbindung zwischen dem Ausgang des ersten invertierenden Verstärkers (1) und dem Eingang des zweiten invertierenden Verstärkers (2) zu gewährleisten, wobei der gemeinsame Pol zwischen dem PMOS-Transistor (211) und dem NMOS-Transistor (212) dieser Inverterstufe (21) mit dem Gate des NMOS-Transistors (232) der genannten dritten Inverterstufe (23) verbunden ist und das Gate der PMOS-Transistoren (221; 231; 241) dieser zweiten, dritten und vierten Inverterstufe (22, 23, 24) mit dem gemeinsamen Pol der zweiten Inverterstufe (22) bzw. der vierten Inverterstufe (24) verbunden ist, wobei der gemeinsame Pol der P-, NMOS-Transistoren (231, 232) der dritten Inverterstufe (23) den Ausgang dieses zweiten invertierenden Verstärkers (2) bildet, der das genannte zweite Logiksignal mit verstärkter mittlerer Amplitude abgibt,
   - eine Rückkopplungs-Schaltung, bestehend aus einem ersten und einem zweiten Rückkopplungs-NMOS-Transistor (212a, 222a), die jeweils parallel mit dem NMOS-Transistor (212, 222) der ersten bzw. zweiten Inverterstufe (21 bzw. 22) verbunden sind, wobei das Gate dieser Rückkopplungs-Transistoren (212a, 222a) am Ausgang dieses zweiten invertierenden Verstärkers (2) angeschlossen ist.

5. Schnittstellenschaltung nach einem der Ansprüche 1 bis 4, **dadurch gekennzeichnet, daß** die genannte Signalformerschaltung (3) eine Inverterstufe (30) aufweist, die aus zwei in Kaskade geschalteten P-, NMOS-Transistoren (301, 302) gebildet ist, wobei die Gates dieser P-, NMOS-Transistoren, die den Eingang dieser Signalformerschaltung bilden, am Ausgang des genannten zweiten invertierenden Verstärkers (2) angeschlossen sind und der gemeinsame Pol dieser P-, NMOS-Transistoren, der den Ausgang dieser Signalformerschaltung (3) bildet, dieses zweite invertierte logische TTL-Signal abgibt.

6. Schnittstellenschaltung nach einem der Ansprüche 1 bis 5, **dadurch gekennzeichnet, daß** der genannte invertierende Leistungsverstärker (4) eine Inverterstufe aufweist, die aus zwei in Kaskade geschalteten P-, NMOS-Transistoren (401, 402) gebildet ist, wobei das Gate dieser P-, NMOS-Transistoren, das den Eingang dieses invertierenden Leistungsverstärkers bildet, am Ausgang der genannten Signalformerschaltung (3) angeschlossen ist und der gemeinsame Pol der beiden P-, NMOS-Transistoren (401, 402), der den Ausgang dieses invertierenden Verstärkers bildet, das genannte verstärkte logische TTL-Signal abgibt.

7. Schnittstellenschaltung nach einem der Ansprüche 2 bis 6, **dadurch gekennzeichnet, daß** die Steuerschaltung (5), die es ermöglicht, den statischen Stromverbrauch im Standby-Modus zu reduzieren, aufweist: eine erste, eine zweite, eine dritte und eine vierte Inverterstufe (50, 51, 52, 53), die jeweils aus zwei in Kaskade geschalteten P-, NMOS-Transistoren (501, 502; 511, 512; 521, 522; 531, 532) bestehen, wobei diese Inverterstufen parallel zwischen der Versorgungsspannung und der Referenzspannung geschaltet sind, wobei der gemeinsame Pol dieser P-, NMOS-Transistoren mit den Gates der P-, NMOS-Transistoren der nächsten Inverterstufe verbunden ist, wobei der gemeinsame Pol der P-, NMOS-Transistoren (531, 532) der vierten Inverterstufe, der den Ausgang des Steuerschaltkreises (5) bildet, einerseits mit dem Gate des genannten PMOS-Leistungstransistors (12) des genannten ersten invertierenden Verstärkers (1) und andererseits mit dem Gate eines ersten und eines zweiten Sperr-NMOS-Transistors (252, 252a) verbunden ist, die parallel zwischen Gate und Referenzspannung der genannten Rückkopplungs-Transistoren (212a) des zweiten invertierenden Verstärkers bzw. zwischen Gate und Referenzspannung der NMOS-Transistoren (212, 222) der zweiten und der dritten Inverterstufe (21, 22) des zweiten invertierenden Verstärkers (2) geschaltet sind.

**Claims**

1. A device for interfacing logic signals from the BTL level to the TTL and CMOS level, characterized in that said device comprises, fed by a power supply voltage at the TTL level with respect to a reference voltage, and connected in cascade:

   - a first amplifier-inverter (1) formed by an input amplifier with feedback provided with a structure imposing self compensation and constant frequency gain and receiving said logic signal at the BTL level on one input, and delivering a first inverted logic signal, of intermediate amplitude,

   - a second amplifier-inverter (2), receiving said first inverted logic signal of intermediate amplitude and delivering a second logic signal of amplified intermediate amplitude,

   - a shaping circuit (3), receiving said second logic signal of amplified intermediate amplitude and delivering an inverted logic signal at the TTL level,

   - a power inverter-amplifier circuit (4) receiving said inverted logic signal at the TTL level and delivering an amplified logic signal at the TTL level.

2. Device according to Claim 1, characterized by said first and second amplifier-inverters including a control circuit receiving a control signal allowing to reduce the static electrical energy consumption in standby mode.

3. Device according to Claim 1 or 2, characterized by said first amplifier-inverter (1) comprising:

   - a first inverter stage (10) formed by two P, N MOS transistors (101,102) connected in cascade, the gate of said P MOS transistor (101) forming the input of said interfacing device and receiving said logic signal at the BTL level,

   - a second inverter stage (11) formed by two P, N MOS transistors (111,112) connected in cascade, said first and said second inverter stage being connected in parallel between said reference voltage and a common point,

   - a P MOS power transistor (12) interconnected between said power supply voltage and said common point,

   - a third inverter stage (13) formed by two P, N MOS transistors (131,132) connected in cascade, between said power supply voltage and said reference voltage, the common point between P, N MOS transistors of said third inverter stage forming the output terminal of said first amplifier-inverter and delivering said first inverted logic signal of intermediate amplitude,

   - a fourth inverter stage (14), the gate electrode of the P MOS transistor (141) of said fourth inverter stage (14) being connected to the common point of the P MOS and N MOS transistors (141,142) of said fourth inverter stage and the gate electrode of the N MOS transistor (142) of said fourth inverter stage (14) being connected to the common point of said first inverter stage (10) of said first amplifier-inverter (1),

   - a feedback circuit formed by a first (102a) and a second (112a) feedback N MOS transistor each connected in parallel with the N MOS transistor (102,112) of the first and second inverter stage respectively, the gate of said feedback transistors being connected at the output of said first amplifier-inverter.

4. Device according to one of the Claims 1 to 3 characterized by said second amplifier-inverter (2) comprising:

   - a first, a second, a third, a fourth and a fifth inverter stage (21,22,23,24), each formed by two P, N MOS transistors connected in cascade (211,212; 221,222; 231,232), said inverter stages being connected in parallel between said power supply voltage and said reference voltage, the first amplifier-inverter output (1) being connected to the gate electrode of the P MOS transistor (211) of said inverter stage (21), so as to perform the interconnection between the first amplifier-inverter output (1) and the second amplifier-inverter input (2), the common point between the P MOS transistor (211) and the N MOS transistor (212) of said first inverter stage (21) being connected to the gate electrode of the N MOS transistor (232) of said third inverter stage (23) and the gate electrode of the P MOS transistors (221,231,241) of said second, third and fourth inverter stages (22,23,24) being interconnected to the common point of said second (22) and fourth (24) inverter stage respectively, the common point of the P MOS and N MOS transistors (231,232) of said third inverter stage (23) forming the output of said second amplifier-inverter (2) delivering said second logic signal of amplified intermediate amplitude,
   - a feedback circuit formed by a first (212a) and a second (222a) feedback N MOS transistor each connected in parallel with the N MOS transistor (212,222) of said second and third inverter stage respectively, the gate of said feedback transistors (212a,222a) being connected to the output of said second amplifier-inverter (2).

5. Device according to one of the Claims 1 to 4, characterized by said shaping circuit (3) comprising an inverter stage (30) formed by two P, N MOS transistors (301,302) connected in cascade, the gates of said P, N MOS transistors forming the input of said shaping circuit being connected at the output of said second amplifier-inverter (2), and the common point of said P, N MOS transistors forming the output of said shaping circuit (3) delivering said second inverted logic signal at the TTL level.

6. Device according to one of the Claims 1 to 5, characterized by said power inverter-amplifier circuit (4) comprising an inverter stage formed by two P, N MOS transistors (401,402) connected in cascade, the gate of said P, N MOS transistors forming the input of said power inverter-amplifier circuit being connected at the output of said shaping circuit (3) and the common point of the two P, N MOS transistors (401,402) forming an output of said inverter-amplifier circuit delivering said amplified logic signal at the TTL level.

7. Device according to one of the Claims 2 to 6, characterized by said control circuit (5) allowing to reduce the static electrical energy consumption in standby mode comprising: a first (50), second (51), third (52) and fourth (53) inverter stage, each formed by two P, NMOS transistors (501,502; 511,512; 521,522; 531,532) in cascade, these inverter stages being connected in parallel between the power supply voltage and the reference voltage, the common point of said P, N MOS transistors being connected to the gates of the P, N MOS transistors of the following inverter stage, the common point of the P, N MOS transistors (531,532) of the fourth inverter stage forming an output of the control circuit (5) and being connected, on the one hand, to the gate of said P MOS power transistor (12) of said first amplifier-inverter (1) and, on the other hand, to the gate of a first (252) and of a second (252a) inhibitor N MOS transistor connected in parallel between gate and reference voltage of said feedback transistors (212a) of the second amplifier-inverter respectively between gate and reference voltage of the N MOS transistors (212,222) of said second (21) and of said third (22) inverter stage of said second amplifier-inverter (2).

FIG.1.

FIG.2.